# EUROPÄISCHE PATENTSCHRIFT

(11) **EP 4 552 155 B1**
(45) Veröffentlichungstag und Bekanntmachung des Hinweises auf die Patenterteilung: **18.03.2026**
(21) Anmeldenummer: 23753871.5
(22) Anmeldetag: 03.08.2023
(51) Int. Cl.: H01L 23/34, H01L 23/373, H05K 1/02, H05K 1/18, H05K 3/46, G01R 15/00

(54) **ANORDNUNG MIT MINDESTENS EINEM PASSIVEN BAUELEMENT**
ARRANGEMENT WITH AT LEAST ONE PASSIVE COMPONENT
AGENCEMENT DOTÉ D'AU MOINS UN COMPOSANT PASSIF

(30) Priorität: 15.09.2022 EP 22195903
(43) Veröffentlichungstag der Anmeldung: 14.05.2025
(73) Patentinhaber: Siemens Aktiengesellschaft, 80333 München (DE)
(72) Erfinder: PFEFFERLEIN, Stefan, 90562 Heroldsberg (DE); HENSLER, Alexander, 91466 Gerhardshofen (DE); STROGIES, Jörg, 14163 Berlin (DE)
(74) Vertreter: Siemens Patent Attorneys
(86) Internationale Anmeldenummer: PCT/EP2023/071571
(87) Internationale Veröffentlichungsnummer: WO 2024/056275

(56) Entgegenhaltungen:
- EP-A1- 1 455 391
- EP-A1- 3 139 407
- WO-A1-2017/222165
- DE-A1- 102014 219 759
- DE-A1- 102020 212 773
- DE-A1- 102021 202 197
- US-A1- 2021 066 199

## Beschreibung

Die Erfindung betrifft eine Anordnung mit mindestens einem passiven Bauelement, einem ersten Substrat einem mit dem ersten Substrat elektrisch leitend verbundenen zweiten Substrat und einer Wärmesenke.

Ferner betrifft die Erfindung einen Stromrichter mit mindestens einer derartigen Halbleiteranordnung.

Verfahren zur Herstellung einer Anordnung mit mindestens einem passiven Bauelement, einem ersten Substrat einem mit dem ersten Substrat elektrisch leitend verbundenen zweiten Substrat und einer Wärmesenke.

Derartige Anordnungen kommen beispielsweise in einem Stromrichter zum Einsatz. Unter einem Stromrichter ist beispielsweise ein Gleichrichter, ein Wechselrichter, ein Umrichter oder ein Gleichspannungswandler zu verstehen. In einem Stromrichter können passive Bauelemente wie Kondensatoren, Snubber aber auch Sensoren, unter anderem zur Ermittlung von Strömen, Spannungen oder Temperaturen, zum Einsatz kommen, die üblicherweise mit einem Substrat verbunden sind. Derartige Sensoren können beispielsweise einen Strommesswiderstand, einen sogenannten Shunt-Widerstand oder einen Negative Temperature Coefficient Thermistor, kurz NTC, umfassen. Die passiven Bauelemente können, z.B. um genaue Messergebnisse zu erzielen, in einen stromführenden Pfad oder im Bereich einer Wärmequelle angeordnet werden, wobei eine ausreichende Entwärmung zu gewährleisten ist.

Die Offenlegungsschrift WO 2020/249479 A1 beschreibt einen elektronischen Schaltkreis mit einem ersten und einem zweiten Schaltungsträger sowie einem ersten und einem zweiten Halbleiterbauelement. Das erste Halbleiterbauelement liegt mit einer Oberseite an einer Unterseite des ersten Schaltungsträgers an sowie mit einer Unterseite an einer Oberseite des zweiten Schaltungsträgers. Der erste Schaltungsträger weist eine erste Durchkontaktierung auf, welche das erste Halbleiterbauelement mit einer ersten Leiterbahn verbindet. Der erste Schaltungsträger weist eine zweite Durchkontaktierung auf, welche ein zwischen den Schaltungsträgern angeordnetes Verbindungselement mit einer weiteren Leiterbahn elektrisch verbindet.

DE 10 2021 202197 A1 (BOSCH GMBH ROBERT [DE]) 8. September 2022 (2022-09-08) offenbart eine Anordnung mit mindestens einem passiven Bauelement, einem ersten Substrat, einem mit dem ersten Substrat elektrisch leitend verbundenen zweiten Substrat und einer Wärmesenke.

US 2021/066199 A1 (FEICHTINGER THOMAS [AT] ET AL) 4. März 2021 (2021-03-04) offenbart ein elektronisches Gerät mit mindestens einen ersten Träger und mindestens einen Halbleiterchip, wobei der erste Träger einen Hohlraum aufweist, in dem der Halbleiterchip angeordnet ist.

EP 3 139 407 A1 (ST MICROELECTRONICS SRL [IT]) 8. März 2017 (2017-03-08) offenbart ein elektronisches Leistungsmodul mit verbesserter Wärmeableitung.

Insbesondere bei einer derartigen planaren Aufbau- und Verbindungstechnik ist eine ausreichende Wärmeabfuhr eine Herausforderung. Vor diesem Hintergrund ist es eine Aufgabe der vorliegenden Erfindung, eine verbesserte Entwärmung für eine Anordnung der eingangs genannten Art zu ermöglichen.

Diese Aufgabe wird erfindungsgemäß gelöst durch eine Anordnung mit mindestens einem passiven Bauelement, einem ersten Substrat, einem mit dem ersten Substrat elektrisch leitend verbundenen zweiten Substrat und einer Wärmesenke, wobei das erste Substrat eine erste Leiterbahn und eine zweite Leiterbahn aufweist, wobei die erste Leiterbahn über das passive Bauelement elektrisch leitend mit der zweiten Leiterbahn verbunden ist, wobei das zweite Substrat eine zweite dielektrische Materiallage umfasst und wobei das passive Bauelement über die zweite dielektrische Materiallage des zweiten Substrats elektrisch isolierend und thermisch leitend mit der Wärmesenke, welche auf einer dem ersten Substrat abgewandten Seite des zweiten Substrats angeordnet ist, verbunden ist, wobei das passive Bauelement, welches als mindestens ein Shunt-Widerstand ausgeführt ist, auf einer dem ersten Substrat zugewandten Seite des zweiten Substrats angeordnet ist, wobei das erste Substrat eine Kavität oder eine Aussparung aufweist, in welche das passive Bauelement hineinragt.

Ferner wird die Aufgabe erfindungsgemäß gelöst durch eine Anordnung mit mindestens einem passiven Bauelement, einem ersten Substrat, einem mit dem ersten Substrat elektrisch leitend verbundenen zweiten Substrat und einer Wärmesenke, wobei das erste Substrat eine erste Leiterbahn und eine zweite Leiterbahn aufweist, wobei die erste Leiterbahn über das passive Bauelement elektrisch leitend mit der zweiten Leiterbahn verbunden ist, wobei das zweite Substrat eine zweite dielektrische Materiallage umfasst und wobei das passive Bauelement über die zweite dielektrische Materiallage des zweiten Substrats elektrisch isolierend und thermisch leitend mit der Wärmesenke, welche auf einer dem ersten Substrat abgewandten Seite des zweiten Substrats angeordnet ist, verbunden ist, wobei das das passive Bauelement, welches als mindestens ein Shunt-Widerstand ausgeführt ist, auf einer dem zweiten Substrat zugewandten Seite des ersten Substrats angeordnet ist, wobei das passive Bauelement in einer Kavität des ersten Substrats angeordnet ist.

Überdies wird die Aufgabe erfindungsgemäß gelöst durch einen Stromrichter mit mindestens einer derartigen Anordnung.

Darüber hinaus wird die Aufgabe erfindungsgemäß gelöst durch ein Verfahren zur Herstellung einer Anordnung mit mindestens einem passiven Bauelement, einem ersten Substrat, einem mit dem ersten Substrat elektrisch leitend verbundenen zweiten Substrat und einer Wärmesenke, wobei das erste Substrat eine erste Leiterbahn und eine zweite Leiterbahn aufweist, wobei über das passive Bauelement eine elektrisch leitende Verbindung zwischen der ersten Leiterbahn und der zweiten Leiterbahn hergestellt wird, wobei das zweite Substrat eine zweite dielektrische Materiallage umfasst und wobei das passive Bauelement über die zweite dielektrische Materiallage des zweiten Substrats elektrisch isolierend und thermisch leitend mit der Wärmesenke, welche auf einer dem ersten Substrat abgewandten Seite des zweiten Substrats angeordnet wird, verbunden wird, wobei das passive Bauelement, welches als mindestens ein Shunt-Widerstand ausgeführt ist, auf einer dem ersten Substrat zugewandten Seite des zweiten Substrats angeordnet wird, wobei das erste Substrat eine Kavität oder eine Aussparung aufweist, in welche das passive Bauelement hineinragt.

Darüber hinaus wird die Aufgabe erfindungsgemäß gelöst durch ein Verfahren zur Herstellung einer Anordnung mit mindestens einem passiven Bauelement, einem ersten Substrat, einem mit dem ersten Substrat elektrisch leitend verbundenen zweiten Substrat und einer Wärmesenke, wobei das erste Substrat eine erste Leiterbahn und eine zweite Leiterbahn aufweist, wobei über das passive Bauelement eine elektrisch leitende Verbindung zwischen der ersten Leiterbahn und der zweiten Leiterbahn hergestellt wird, wobei das zweite Substrat eine zweite dielektrische Materiallage umfasst und wobei das passive Bauelement über die zweite dielektrische Materiallage des zweiten Substrats elektrisch isolierend und thermisch leitend mit der Wärmesenke, welche auf einer dem ersten Substrat abgewandten Seite des zweiten Substrats angeordnet wird, verbunden wird, wobei das das passive Bauelement, welches als mindestens ein Shunt-Widerstand ausgeführt ist, auf einer dem zweiten Substrat zugewandten Seite des ersten Substrats angeordnet wird, wobei das passive Bauelement in einer Kavität des ersten Substrats angeordnet wird.

Der Erfindung liegt unter anderem die Überlegung zugrunde, eine Entwärmung einer Anordnung mit einem passiven Bauelements, welches eine erste Leiterbahn elektrisch leitend mit einer zweiten Leiterbahn verbindet, zu verbessern, indem dieses elektrisch isolierend und thermisch leitend mit einer Wärmesenke verbunden wird. Das passive Bauelement kann unter anderem als ein Sensor, insbesondere als ein Stromsensor, z.B. ein Shunt-Widerstand, oder Temperatursensor, z.B. ein NTC, aber auch als reaktives Bauelement, z.B. ein Snubber, ausgeführt sein. Insbesondere wenn das passive Bauelement in einem stromführenden Pfad oder im Bereich einer Wärmequelle, beispielsweise eines Leistungstransistors eines Stromrichters, angeordnet ist, wird eine während des Betriebes der Anordnung entstehende Wärme, insbesondere Verlustwärme, über die Wärmesenke abgeführt. Die Wärmesenke kann unter anderem als Kühlkörper ausgeführt sein. Die erste und die zweite Leiterbahn sind auf einem ersten Substrat angeordnet, welches unter anderem als, insbesondere mehrlagige, PCB (Printed Circuit Board) ausgeführt sein kann. Die Anordnung umfasst weiterhin ein mit dem ersten Substrat elektrisch leitend verbundenes zweites Substrat, welches eine dielektrische Materiallage umfasst und unter anderem als, insbesondere zweilagiges, DCB-Substrat (direct bonded copper) ausgeführt sein kann. Das passiven Bauelement kann zur Herstellung der elektrisch leitenden Verbindung zwischen der ersten und der zweiten Leiterbahn auf dem ersten Substrat oder dem zweiten Substrat angeordnet sein. Die Wärmesenke ist auf einer dem ersten Substrat abgewandten Seite des zweiten Substrats angeordnet. Somit ist das mit dem ersten Substrat elektrisch leitend verbundene zweite Substrat zwischen dem ersten Substrat und der Wärmesenke angeordnet, wobei das zweite Substrat flächig auf der Wärmesenke aufliegen und mit dieser verbunden sein kann. Über die zweite dielektrische Materiallage des zweiten Substrats wird das passive Bauelement elektrisch isolierend und thermisch leitend mit der Wärmesenke verbunden. Somit wird eine während des Betriebes der Anordnung entstehende Wärme nicht nur über die erste und zweite Leiterbahn, sondern auch über die elektrisch isolierende und thermisch leitende Verbindung mit der Wärmesenke abgeführt. Durch diesen zusätzlichen Wärmepfad wird eine verbesserte Entwärmung der Anordnung erreicht.

Das passive Bauelement ist auf einer dem ersten Substrat zugewandten Seite des zweiten Substrats angeordnet. Durch eine derartige Anordnung wird der thermische Widerstand zur Wärmesenke verringert, sodass eine verbesserte thermische Kontaktierung erzielt wird, was, beispielsweise bei höheren Leistungen von Stromrichtern, die bei mehr als 150 kW, insbesondere bei mehr als 750 kW liegen können, die Messgenauigkeit verbessert und eine lange Lebensdauer ermöglicht.

Das erste Substrat weist eine Kavität oder eine Aussparung auf, in welche das passive Bauelement hineinragt. Durch eine Kavität oder eine Aussparung wird der Abstand zwischen dem ersten Substrat, insbesondere PCB, und dem zweiten Substrat, insbesondere DCB, verringert, was den erforderlichen Bauraum reduziert. Ferner wird bei einer Anbindung eines Halbleiterelements, beispielsweise eines vertikalen Leistungstransistors, an das erste Substrat über eine weitere DCB wird die Verwendung eines gemeinsamen Kühlkörpers mit einer ebenen Oberfläche ermöglicht. Da passive Bauelemente, wie Shunt-Widerstände, üblicherweise die Dicke eines derartigen Halbleiterelements überschreiten und dieser Höhenunterschied durch eine Kavität oder eine Aussparung ausgleichbar ist.

Alternativ ist das passive Bauelement auf einer dem zweiten Substrat zugewandten Seite des ersten Substrats angeordnet. Eine derartige Anordnung ermöglicht einen geringen Verdrahtungswiderstand zum passiven Bauelement und eine ausreichende thermische Kontaktierung zur Wärmesenke.

Das passive Bauelement ist in einer Kavität des ersten Substrats angeordnet. Ein Abstand des zweiten Substrats zum ersten Substrat ist durch die Tiefe der Kavität einstellbar. Bei einer Anbindung eines Halbleiterelements, beispielsweise eines vertikalen Leistungstransistors, an das erste Substrat über eine weitere DCB wird die Verwendung eines gemeinsamen Kühlkörpers mit einer ebenen Oberfläche ermöglicht. Da passive Bauelemente, wie Shunt-Widerstände, üblicherweise die Dicke eines derartigen Halbleiterelements überschreiten und dieser Höhenunterschied durch eine Kavität oder eine Aussparung ausgleichbar ist.

Eine weitere Ausführungsform sieht vor, dass das passive Bauelement als Sensor ausgeführt ist, wobei die Anordnung zumindest einen Anschluss zur Kontaktierung des Sensors umfasst. Beispielsweise ist der Sensor als Shunt-Widerstand ausgeführt, welcher Zeranin, Manganin, Konstantan, Isaohm enthält. Durch die zusätzliche thermische Anbindung über das zweite Substrat an die Wärmesenke wird eine verbesserte Entwärmung erreicht, sodass eine hohe Messgenauigkeit und lange Lebensdauer erzielbar sind.

Eine weitere Ausführungsform sieht vor, dass das passive Bauelement auf einer dem zweiten Substrat abgewandten Seite des ersten Substrats angeordnet ist. Die thermische Anbindung an die Wärmesenke über das zweite Substrat kann beispielsweise über metallische Durchkontaktierungen durch das erste Substrat erfolgen. Für das passive Bauelement sind unter anderem diskrete Standard-SMD-Komponenten verwendbar. Eine derartige Anordnung ist einfach und kostengünstig realisierbar.

Eine weitere Ausführungsform sieht vor, dass das passive Bauelement über einen ersten Kontakt elektrisch leitend mit der ersten Leiterbahn und über einen zweiten Kontakt elektrisch leitend mit der zweiten Leiterbahn verbunden ist, wobei das passive Bauelement einen zwischen dem ersten Kontakt und dem zweiten Kontakt angeordneten Aktivteil aufweist, über welchen das passive Bauelement thermisch leitend mit einer ersten Metallisierung des zweiten Substrats verbunden ist. Durch eine derartige Anordnung wird eine sehr gute thermische Anbindung des passiven Bauelements an die Wärmesenke erreicht.

Eine weitere Ausführungsform sieht vor, dass die thermisch leitende Verbindung des Aktivteils des passiven Bauelements mit der ersten Metallisierung des zweiten Substrats durch eine stoffschlüssige Verbindung hergestellt ist. Eine derartige stoffschlüssige Verbindung ist unter anderem durch Löten, Sintern oder durch einen thermisch leitfähigen Kleber herstellbar. Durch eine derartige stoffschlüssige Verbindung wird eine optimierte thermische Anbindung des passiven Bauelements an die Wärmesenke erreicht.

Eine weitere Ausführungsform sieht vor, dass die erste Leiterbahn und die zweite Leiterbahn jeweils über mindestens ein VIA mit dem zweiten Substrat verbunden sind, wobei das passive Bauelement einen Aktivteil aufweist und wobei die VIAs innerhalb einer senkrechten Projektionsfläche des Aktivteils des passive Bauelements verlaufend angeordnet sind. Ein VIA (vertical interconnect access) kann unter anderem eine zumindest teilweise metallische Durchkontaktierung sein, welche z.B. Metallisierungen unterschiedlicher Lagen eines Substrats miteinander verbindet. Durch eine derartige Anordnung wird ein geringerer Abstand zwischen den VIAs erreicht. Aus Isolationsgründen kann es erforderlich sein, dass die VIAs vom zweiten Substrat bedeckt sind. Durch einen geringeren Abstand der VIAs wird ein kompakteres zweites Substrat ermöglicht, was sich positiv auf die Kosten für die Anordnung auswirkt.

Eine weitere Ausführungsform sieht vor, dass das passive Bauelement eine im Wesentlichen C-förmige Querschnittskontur aufweist, wobei Kontakte des passiven Bauelements, welche mit der ersten und zweiten Leiterbahn verbunden sind, aufeinander zuweisend angeordnet sind. Insbesondere sind durch eine derartige C-förmige Querschnittskontur mit der ersten und zweiten Leiterbahn verbundene Kontakte des passiven Bauelements aufeinander zuweisend ausgeführt. Beispielsweise weist das passive Bauelement ein unterbrochen umlaufendes Profil auf, wobei Kontakte auf einer Außenfläche des unterbrochen umlaufenden Profils angeordnet und im Bereich der Unterbrechung mit der jeweiligen Leiterbahn verbunden sind. Dadurch wird ein geringerer Abstand zwischen den VIAs der jeweiligen Leiterbahnen erreicht.

Eine weitere Ausführungsform sieht vor, dass eine erste Breite des zweiten Substrats kleiner als eine zweite Breite des passiven Bauelements ist. Durch ein derartiges Substrat werden die Kosten für die Anordnung gesenkt.

Eine weitere Ausführungsform sieht vor, dass das passive Bauelement, insbesondere vollständig, vergossen ist. Beispielsweise ist zwischen de ersten und dem zweiten Substrat ein Vergussmaterial angeordnet, in welchem das passive Bauelement eingebettet ist.

Eine weitere Ausführungsform sieht mindestens ein Halbleiterelement vor, welches elektrisch leitend mit dem passiven Bauelement verbunden ist, und ein drittes Substrat, welches über das Halbleiterelement mit dem ersten Substrat verbunden ist, wobei das Halbleiterelement und das dritte Substrat auf einer dem zweiten Substrat zugewandten Seite des ersten Substrats angeordnet sind, wobei das dritte Substrat eine dritte dielektrische Materiallage umfasst und wobei das Halbleiterelement über die dritte dielektrische Materiallage des dritten Substrats elektrisch isolierend und thermisch leitend mit der Wärmesenke verbunden ist. Das Halbleiterelement kann unter anderem als vertikaler Leistungstransistor, insbesondere als Insulated-Gate-Bipolar-Transistor (IGBT), ausgeführt sein. Das zweite Substrat und das dritte Substrat sind insbesondere mit einer gemeinsamen Wärmesenke verbunden. Das passive Bauelement, welches beispielsweise als mindestens ein Shunt-Widerstand ausgeführt ist, und das mit dem mindestens einen Shunt-Widerstand verbundene Halbleiterelement können unter anderem Teil eines Stromrichters sein. Durch eine derartige Anordnung können der Shunt-Widerstand und das Halbleiterelement effektiv gekühlt werden, sodass auch bei höheren Leistungen des Stromrichters auf ein separates Shunt-Modul verzichtet werden kann.

Eine weitere Ausführungsform sieht vor, dass das zweite Substrat dicker als das dritte Substrat ausgeführt ist. Da insbesondere diskrete Shunt-Widerstände üblicherweise in ihrer Höhe deutlich die Dicke des Halbleiterelements überschreiten, kann ein Höhenausgleich, insbesondere bei geringer Shunt-Dicke, über eine derartige Lagendickenanpassung der jeweiligen dielektrischen Materiallagen erfolgen, sodass die Verwendung eines gemeinsamen Kühlkörpers mit einer ebenen Oberfläche ermöglicht wird.

Im Folgenden wird die Erfindung anhand der in den Figuren dargestellten Ausführungsbeispiele näher beschrieben und erläutert.

Es zeigen:
- FIG 1: eine schematische Querschnittsdarstellung einer ersten Ausführungsform einer Anordnung mit einem passiven Bauelement,
- FIG 2: eine schematische Querschnittsdarstellung einer zweiten Ausführungsform einer Anordnung mit einem passiven Bauelement,
- FIG 3: eine schematische Querschnittsdarstellung einer dritten Ausführungsform einer Anordnung mit einem passiven Bauelement,
- FIG 4: eine schematische Darstellung einer vierten Ausführungsform einer Anordnung mit passiven Bauelementen in einer Draufsicht,
- FIG 5: eine schematische Querschnittsdarstellung einer fünften Ausführungsform einer Anordnung mit einem passiven Bauelement,
- FIG 6: eine schematische Querschnittsdarstellung einer sechsten Ausführungsform einer Anordnung mit einem passiven Bauelement,
- FIG 7: eine schematische Querschnittsdarstellung einer Anordnung mit einem passiven Bauelement und einem Halbleiterelement,
- FIG 8: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

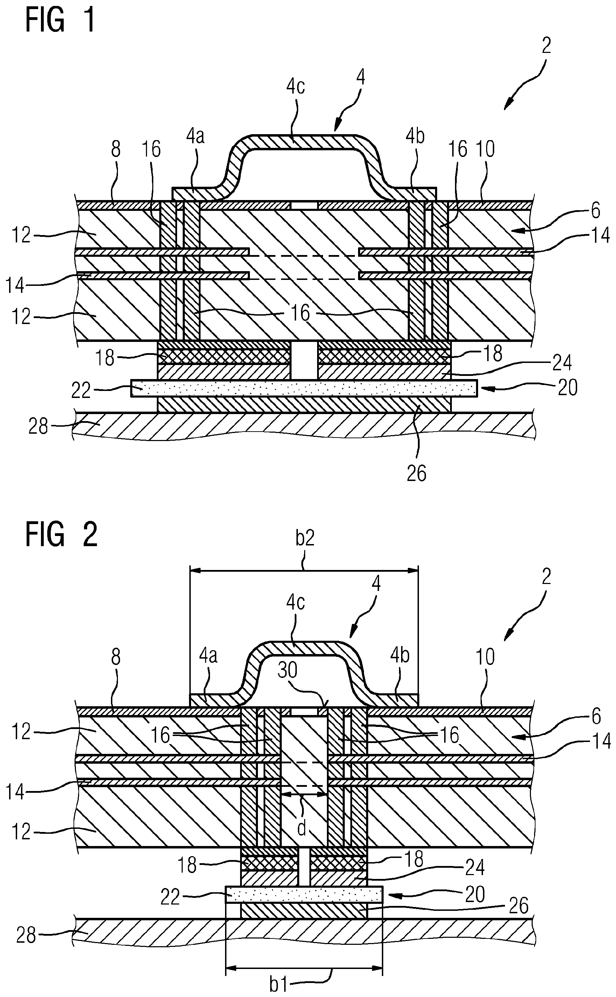

FIG 1 zeigt eine schematische Querschnittsdarstellung einer ersten Ausführungsform einer Anordnung 2 mit einem passiven Bauelement 4, das auf einem ersten Substrat 6 kontaktiert ist. Das erste Substrat 6, das als PCB (Printed Circuit Board) ausgeführt ist, umfasst eine erste Leiterbahn 8 und eine zweite Leiterbahn 10, wobei die erste Leiterbahn 8 über das passive Bauelement 4, welches über eine stoffschlüssige Verbindung, insbesondere eine Löt- oder Sinterverbindung, elektrisch leitend mit der zweiten Leiterbahn 10 verbunden ist. Ferner umfasst das erste Substrat 6 beispielhaft drei erste dielektrische Materiallagen 12, welche beispielsweise aus FR4 hergestellt sind. Die erste Leiterbahn 8 und die zweite Leiterbahn 10 umfassen jeweils parallel geschaltete Metallisierungen 14, insbesondere Kupfermetallisierungen, welche auf den ersten dielektrischen Materiallagen 12 angeordnet sind, wodurch eine höhere Stromtragfähigkeit erreicht wird. Die Parallelschaltung erfolgt jeweils über VIAs 16 (vertical interconnect access), welche die Metallisierungen 14 elektrisch leitend verbinden. Darüber hinaus sind die Leiterbahnen 8, 10 des ersten Substrats 6 über die VIAs 16 mit Abstandshalteelementen 18 verbunden, welche eine elektrisch und thermisch leitfähige Verbindung zu einem zweiten Substrat 20 herstellen. Das Abstandshalteelementen 18, welches auch Umsteiger genannt wird, ist stoffschlüssig, beispielsweise durch eine Löt- oder Sinterverbindung, mit dem ersten Substrat 6 und dem zweiten Substrat 20 verbunden. Somit sind die erste Leiterbahn 8 und die zweite Leiterbahn 10, auf welchen das passive Bauelement 4 verbunden ist, jeweils über VIAs 16 mit zweiten Substrat 20 verbunden.

Das zweite Substrat 20 ist als DCB-Substrat (direct bonded copper) ausgeführt und umfasst eine zweite dielektrische Materiallage 22, welche zwischen einer ersten Metallisierung 24 und einer zweiten Metallisierung 26 angeordnet ist, wobei die erste Metallisierung 24 über die zweite dielektrische Materiallage 22 mit der zweiten Metallisierung 26 elektrisch isolierend und thermisch leitend verbunden ist. Die zweite dielektrische Materiallage 22 kann unter anderem einen keramischen Werkstoff, beispielsweise Aluminiumnitrid oder Aluminiumoxid, einen organischen Werkstoff, beispielsweise ein Polyamid, oder einen mit einem keramischen Werkstoff gefüllten organischen Werkstoff, enthalten. Die erste Metallisierung 24 und die zweite Metallisierung 26 sind aus Kupfer oder einer Kupferlegierung hergestellt. Auf einer dem ersten Substrat 6 abgewandten Seite des zweiten Substrats 20 ist eine, Wärmesenke 28, welche als Kühlkörper ausgeführt ist, angeordnet. Die Wärmesenke 28 ist stoffschlüssig, beispielsweise durch eine Löt- oder Sinterverbindung, mit der zweiten Metallisierung 26 des zweiten Substrats 20 verbunden, sodass das passive Bauelement 4 über die zweite dielektrische Materiallage 22 des zweiten Substrats 20 elektrisch isolierend und thermisch leitend mit der Wärmesenke 28 verbunden ist.

Das passive Bauelement 4, welches auf einer dem zweiten Substrat 20 abgewandten Seite des ersten Substrats 6 angeordnet ist, umfasst einen ersten Kontakt 4a, über welchen das passive Bauelement 4 elektrisch leitend mit der ersten Leiterbahn 8 verbunden ist, und einen zweiten Kontakt 4b, über welchen das passive Bauelement 4 elektrisch leitend mit der zweiten Leiterbahn 10 verbunden ist. Darüber hinaus weist das passive Bauelement 4 einen Aktivteil 4c auf. Beispielhaft ist das passive Bauelement 4 als Sensor, insbesondere als Stromsensor, z.B. ein Shunt-Widerstand, oder Temperatursensor, z.B. ein NTC, ausgeführt. Zumindest der Aktivteil 4c des Sensors ist aus einer Legierung hergestellt, welche unter anderem Zeranin, Manganin, Konstantan, Isaohm oder einen Kaltleiter wie Platin enthalten kann.

FIG 2 zeigt eine schematische Querschnittsdarstellung einer zweiten Ausführungsform einer Anordnung 2 mit einem passiven Bauelement 4. Die VIAs 16, welche die Leiterbahnen 8, 10, auf welchen das passive Bauelement 4 verbunden ist, mit dem zweiten Substrat 20 verbinden, sind innerhalb einer senkrechten Projektionsfläche 30 des Aktivteils 4c des passive Bauelements 4 verlaufend angeordnet, wodurch sich, im Vergleich zur Ausgestaltung in FIG 1, ein geringerer Abstand d zwischen den VIAs 6 der jeweiligen Leiterbahnen 8, 10 ergibt. Da die VIAs 16 aus Isolationsgründen vom zweiten Substrat 20 bedeckt sein müssen, wird durch den geringeren Abstand d ein kompakteres zweites Substrat 20 ermöglicht. Insbesondere ist eine erste Breite b1 des zweiten Substrats 20 geringer als eine zweite Breite b2 des passiven Bauelements 4. Die weitere Ausführung der Anordnung 2 in FIG 2 entspricht der in FIG 1.

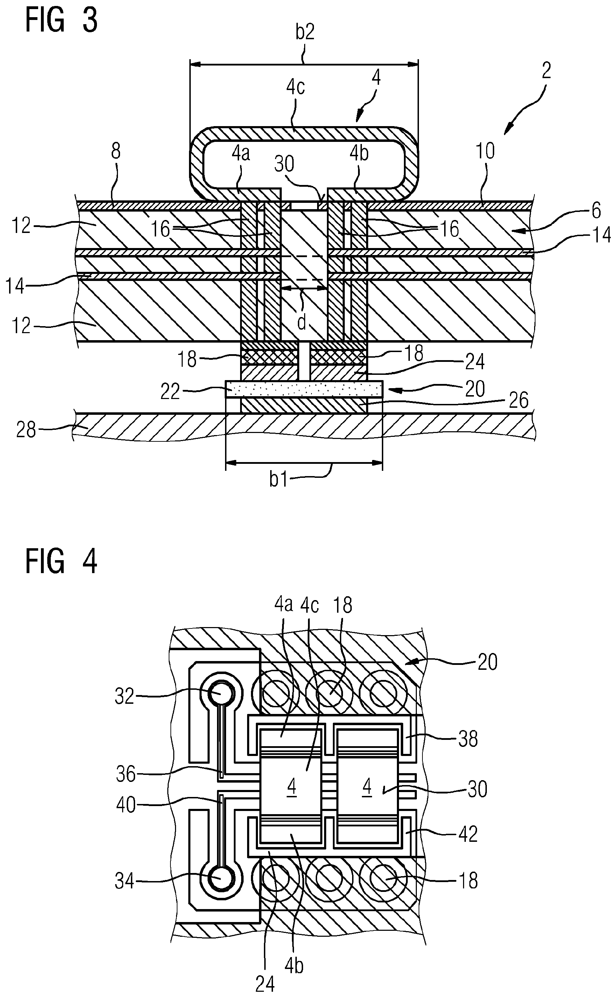

FIG 3 zeigt eine schematische Querschnittsdarstellung einer dritten Ausführungsform einer Anordnung 2 mit einem passiven Bauelement 4, welches eine im Wesentlichen C-förmige Querschnittskontur aufweist. Die Kontakte 4a, 4b des passiven Bauelements 4, welche mit der ersten und zweiten Leiterbahn 8, 10 verbunden sind, sind aufeinander zuweisend angeordnet. Insbesondere ist das passive Bauelement 4 als ein unterbrochen umlaufendes Profil ausgeführt, wobei die Kontakte 4a, 4b auf einer Außenfläche angeordnet und im Bereich der Unterbrechung mit der jeweiligen Leiterbahn 8, 10 verbunden sind. Dadurch wird ein geringerer Abstand d zwischen den VIAs 6 der jeweiligen Leiterbahnen 8, 10 ermöglicht. Insbesondere ist eine erste Breite b1 des zweiten Substrats 20 geringer als eine zweite Breite b2 des passiven Bauelements 4. Die weitere Ausführung der Anordnung 2 in FIG 3 entspricht der in FIG 2.

FIG 4 zeigt eine schematische Darstellung einer vierten Ausführungsform einer Anordnung 2 mit passiven Bauelementen 4 in einer Draufsicht. Die beispielhaft zwei passiven Bauelemente 4 sind als Shunt-Widerstände ausgeführt und auf einer dem ersten Substrat 6 zugewandten Seite des zweiten Substrats 20 angeordnet. Ferner umfasst die Anordnung 2 Anschlüsse 32, 34 zur Kontaktierung der Shunt-Widerstände. Der erste Anschluss 32 ist über eine erste Anschlussleitung 36 mit einer ersten Sensor-Leitung 38 verbunden, während der zweite Anschluss 34 über eine zweite Anschlussleitung 40 mit einer zweiten Sensor-Leitung 42 verbunden ist. Die Anschlussleitungen 36, 38 sind innerhalb einer senkrechten Projektionsfläche 30 der Aktivteile 4c der passiven Bauelemente 4 verlaufend angeordnet. Um Bauraum einzusparen, können die Anschlussleitungen 36, 38 optional übereinander in zwei unterschiedlichen Lagen des PCB übereinander zu führen. Die Sensor-Leitungen 38 sind Teil der ersten Metallisierung 24 des zweiten Substrats 20 und über Abstandshalteelemente 18 mit der jeweiligen Leiterbahn 8, 10 des ersten Substrats 6 verbunden. Die weitere Ausführung der Anordnung 2 in FIG 4 entspricht der in FIG 1.

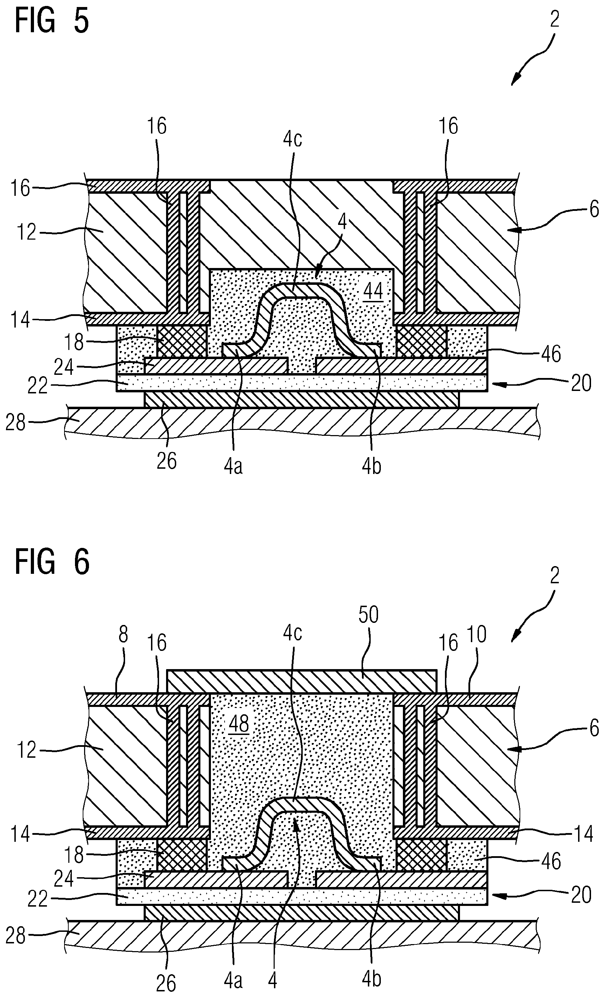

FIG 5 zeigt eine schematische Querschnittsdarstellung einer fünften Ausführungsform einer Anordnung 2 mit einem passiven Bauelement 4, wobei das passive Bauelement 4 auf einer dem ersten Substrat 6 zugewandten Seite des zweiten Substrats 20 angeordnet ist. Das erste Substrat 6 weist eine Kavität 44 auf, in welche das passive Bauelement 4 hineinragt. Die Anordnung umfasst ein Vergussmaterial 46, welches die Kavität 44 ausfüllt und in welches das passive Bauelement 4 eingebettet ist. Die weitere Ausführung der Anordnung 2 in FIG 5 entspricht der in FIG 4.

FIG 6 zeigt eine schematische Querschnittsdarstellung einer sechsten Ausführungsform einer Anordnung 2 mit einem passiven Bauelement 4, wobei das passive Bauelement 4 auf einer dem ersten Substrat 6 zugewandten Seite des zweiten Substrats 20 angeordnet ist. Das erste Substrat 6 weist eine Aussparung 48 auf, in welche das passive Bauelement 4 hineinragt. Die Anordnung umfasst ein Vergussmaterial 46, welches die Aussparung 48 ausfüllt und in welches das passive Bauelement 4 eingebettet ist. Eine Abdeckung 50 verschließt die Aussparung 48 auf einer dem passiven Bauelement 4 gegenüberliegenden Seite des ersten Substrats 6. Die Abdeckung 50 ist vor dem Vergießen temporär oder dauerhaft dichtend, insbesondere stoffschlüssig, an das erste Substrat 6 angebracht und ist optional nach dem Aushärten des Vergussmaterials 46 entfernbar. Die weitere Ausführung der Anordnung 2 in FIG 6 entspricht der in FIG 5.

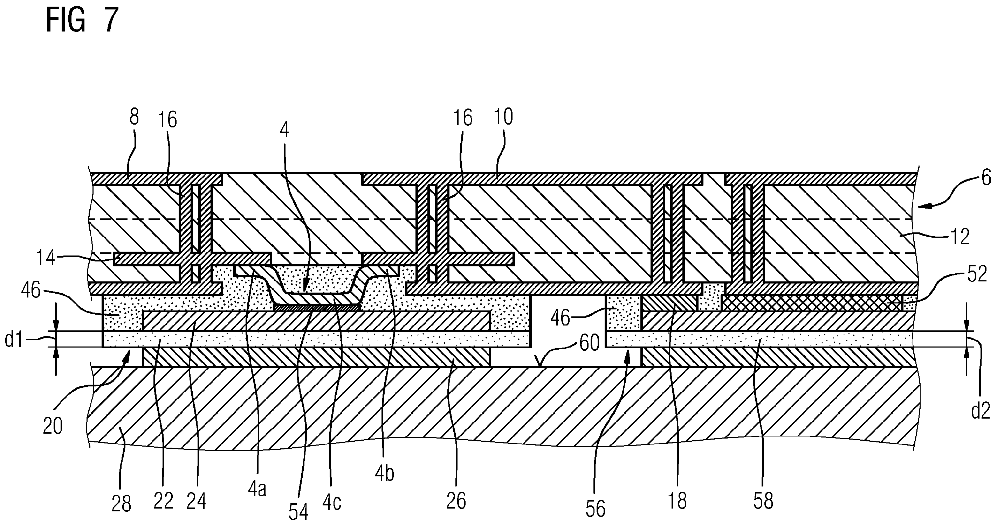

FIG 7 zeigt eine schematische Querschnittsdarstellung einer Anordnung 2 mit einem passiven Bauelement 4 und einem Halbleiterelement 52. Das passive Bauelement 4 ist auf einer dem zweiten 20 zugewandten Seite des ersten Substrats 6 angeordnet. Über den zwischen dem ersten Kontakt 4a und dem zweiten Kontakt 4b angeordneten Aktivteil 4c ist das passive Bauelement 4 thermisch leitend mit der ersten Metallisierung 24 des zweiten Substrats 20 verbunden. Die thermisch leitende Verbindung des Aktivteils 4c des passiven Bauelements 4 mit der ersten Metallisierung 24 des zweiten Substrats 20 wird durch eine stoffschlüssige Verbindung 54 hergestellt, wobei die stoffschlüssige Verbindung 54 unter anderem durch Löten, Sintern oder durch einen thermisch leitfähigen Kleber hergestellt werden kann. Über die stoffschlüssige Verbindung 54 ist das passiven Bauelement 4 thermisch an die Wärmesenke 28 angebunden. Ferner sind keine Abstandshalteelemente 18 erforderlich, wodurch DCB-Fläche eingespart wird.

Das Halbleiterelement 52 ist elektrisch leitend mit dem passiven Bauelement 4 verbunden ist, Das Halbleiterelement 52 ist beispielhaft als vertikaler Leistungstransistor, insbesondere als Insulated-Gate-Bipolar-Transistor (IGBT), ausgeführt. Insbesondere ist das Halbleiterelement 52 als Low Side Schalter einer Halbbrücke für einen Stromrichter konfiguriert, welcher kollektorseitig über das als Shunt-Widerstand ausgebildete passiven Bauelement 4 mit einem AC-Anschluss verbunden ist.

Ferner umfasst die Anordnung 2 ein drittes Substrat 56, welches über das Halbleiterelement 52 und ein Abstandshalteelement 18 mit dem ersten Substrat 6 verbunden ist, wobei das Halbleiterelement 52 und das dritte Substrat 56 auf einer dem zweiten Substrat 20 zugewandten Seite des ersten Substrats 6 angeordnet sind. Das dritte Substrat 20 umfasst eine dritte dielektrische Materiallage 58, wobei das Halbleiterelement 52 über die dritte dielektrische Materiallage 58 des dritten Substrats 56 elektrisch isolierend und thermisch leitend mit einer gemeinsamen Wärmesenke 28 verbunden.

Die gemeinsame Wärmesenke 28 weist eine ebene Oberfläche 60 auf. Da diskrete Shunt-Widerstände üblicherweise in ihrer Höhe deutlich die Halbleiterdicke überschreiten, wird dieser Höhenunterschied durch eine PCB-seitige Kavität 44 ausgeglichen. Das als Shunt-Widerstand ausgeführte passive Bauelement 4 wird in der Kavität 44 des ersten Substrats 6 angeordnet. Der Shunt-Widerstand und das Halbleiterelement 52 werden jeweils in Vergussmaterial 46 eingebettet. Zusätzlich oder alternativ kann der Höhenausgleich, insbesondere bei geringer Shunt-Dicke, über eine Lagendickenanpassung der zweiten dielektrischen Materiallage 22 bzw. der dritten dielektrische Materiallage 58 dahingehend erfolgen, dass eine erste Dicke d1 der zweiten dielektrischen Materiallage 22 geringer gewählt wird als eine zweite Dicke d2 der dritten dielektrische Materiallage 58.

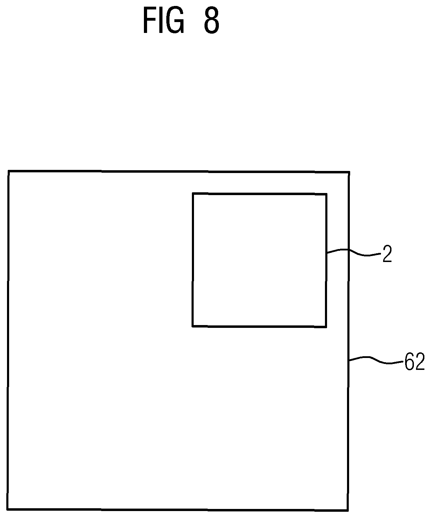

FIG 8 zeigt eine schematische Darstellung eines Stromrichters 62, welcher beispielhaft eine Anordnung 2 umfasst.

## Patentansprüche

1. Anordnung (2) mit mindestens einem passiven Bauelement (4), einem ersten Substrat (6), einem mit dem ersten Substrat (6) elektrisch leitend verbundenen zweiten Substrat (20) und einer Wärmesenke (28),
wobei das erste Substrat (6) zumindest eine erste Leiterbahn (8) und zumindest eine zweite Leiterbahn (10) aufweist, wobei die erste Leiterbahn (8) über das passive Bauelement (4) elektrisch leitend mit der zweiten Leiterbahn (10) verbunden ist,
wobei das zweite Substrat (20) eine zweite dielektrische Materiallage (22) umfasst und
wobei das passive Bauelement (4) über die zweite dielektrische Materiallage (22) des zweiten Substrats (20) elektrisch isolierend und thermisch leitend mit der Wärmesenke (28), welche auf einer dem ersten Substrat (6) abgewandten Seite des zweiten Substrats (20) angeordnet ist, verbunden ist, **dadurch gekennzeichnet, dass**
das passive Bauelement (4), welches als mindestens ein Shunt-Widerstand ausgeführt ist, auf einer dem ersten Substrat (6) zugewandten Seite des zweiten Substrats (20) angeordnet ist, wobei das erste Substrat (6) eine Kavität (44) oder eine Aussparung (48) aufweist, in welche das passive Bauelement (4) hineinragt.

2. Anordnung (2) nach Anspruch 1,
wobei das passive Bauelement (4) als Sensor ausgeführt ist und
die Anordnung (2) zumindest einen Anschluss (32, 34) zur Kontaktierung des Sensors umfasst.

3. Anordnung (2) nach einem der Ansprüche 1 oder 2,
wobei das passive Bauelement (4) auf einer dem zweiten Substrat (20) abgewandten Seite des ersten Substrats (6) angeordnet ist.

4. Anordnung (2) mit mindestens einem passiven Bauelement (4), einem ersten Substrat (6), einem mit dem ersten Substrat (6) elektrisch leitend verbundenen zweiten Substrat (20) und einer Wärmesenke (28),
wobei das erste Substrat (6) zumindest eine erste Leiterbahn (8) und zumindest eine zweite Leiterbahn (10) aufweist, wobei die erste Leiterbahn (8) über das passive Bauelement (4) elektrisch leitend mit der zweiten Leiterbahn (10) verbunden ist,
wobei das zweite Substrat (20) eine zweite dielektrische Materiallage (22) umfasst und
**dadurch gekennzeichnet, dass**
das passive Bauelement (4), welches als mindestens ein Shunt-Widerstand ausgeführt ist, über die zweite dielektrische Materiallage (22) des zweiten Substrats (20) elektrisch isolierend und thermisch leitend mit der Wärmesenke (28), welche auf einer dem ersten Substrat (6) abgewandten Seite des zweiten Substrats (20) angeordnet ist, verbunden ist,
wobei das das passive Bauelement (4) auf einer dem zweiten Substrat (20) zugewandten Seite des ersten Substrats (6) angeordnet ist,
wobei das passive Bauelement (4) in einer Kavität (44) des ersten Substrats (6) angeordnet ist.

5. Anordnung (2) nach Anspruch 4,
wobei das passive Bauelement (4) über einen ersten Kontakt (4a) elektrisch leitend mit der ersten Leiterbahn (8) und über einen zweiten Kontakt (4b) elektrisch leitend mit der zweiten Leiterbahn (10) verbunden ist,
wobei das passive Bauelement (4) einen zwischen dem ersten Kontakt (4a) und dem zweiten Kontakt (4b) angeordneten Aktivteil (4c) aufweist, über welchen das passive Bauelement (4) thermisch leitend mit einer ersten Metallisierung (24) des zweiten Substrats (20) verbunden ist.

6. Anordnung (2) nach Anspruch 5,
wobei die thermisch leitende Verbindung des Aktivteils (4c) des passiven Bauelements (4) mit der ersten Metallisierung (24) des zweiten Substrats (20) durch eine stoffschlüssige Verbindung (54) hergestellt ist.

7. Anordnung (2) nach einem der vorherigen Ansprüche,
wobei die erste Leiterbahn (8) und die zweite Leiterbahn (10) jeweils über mindestens ein VIA (16) mit dem zweiten Substrat (20) verbunden sind,
wobei das passive Bauelement (4) einen Aktivteil (4c) aufweist und
wobei die VIAs (16) innerhalb einer senkrechten Projektionsfläche (30) des Aktivteils (4c) des passive Bauelements (4) verlaufend angeordnet sind.

8. Anordnung (2) nach einem der vorherigen Ansprüche,
wobei das passive Bauelement (4) eine im Wesentlichen C-förmige Querschnittskontur aufweist,
wobei Kontakte (4a, 4b) des passiven Bauelements (4), welche mit der ersten und zweiten Leiterbahn (8, 10) verbunden sind, aufeinander zuweisend angeordnet sind.

9. Anordnung (2) nach einem der vorherigen Ansprüche,
wobei eine erste Breite (b1) des zweiten Substrats (20) kleiner als eine zweite Breite (b2) des passiven Bauelements (4) ist.

10. Anordnung (2) nach einem der vorherigen Ansprüche,
wobei das passive Bauelement (4), insbesondere vollständig, vergossen ist.

11. Anordnung (2) nach einem der vorherigen Ansprüche, aufweisend eine mindestens ein Halbleiterelement (52), welches elektrisch leitend mit dem passiven Bauelement (4) verbunden ist, und ein drittes Substrat (56), welches über das Halbleiterelement (52) mit dem ersten Substrat (6) verbunden ist,
wobei das Halbleiterelement (52) und das dritte Substrat (56) auf einer dem zweiten Substrat (20) zugewandten Seite des ersten Substrats (6) angeordnet sind,
wobei das dritte Substrat (56) eine dritte dielektrische Materiallage (58) umfasst und
wobei das Halbleiterelement (52) über die dritte dielektrische Materiallage (58) des dritten Substrats (56) elektrisch isolierend und thermisch leitend mit der Wärmesenke (28) verbunden ist.

12. Anordnung (2) nach Anspruch 11,
wobei das zweite Substrat (20) dicker als das dritte Substrat (56) ausgeführt ist.

13. Stromrichter (62) mit mindestens einer Anordnung (2) nach einem der vorherigen Ansprüche.

14. Verfahren zur Herstellung einer Anordnung (2) mit mindestens einem passiven Bauelement (4), einem ersten Substrat (6), einem mit dem ersten Substrat (6) elektrisch leitend verbundenen zweiten Substrat (20) und einer Wärmesenke (28),
wobei das erste Substrat (6) eine erste Leiterbahn (8) und eine zweite Leiterbahn (10) aufweist,
wobei über das passive Bauelement (4) eine elektrisch leitende Verbindung zwischen der ersten Leiterbahn (8) und der zweiten Leiterbahn (10) hergestellt wird,
wobei das zweite Substrat (20) eine zweite dielektrische Materiallage (22) umfasst und
wobei das passive Bauelement (4) über die zweite dielektrische Materiallage (22) des zweiten Substrats (20) elektrisch isolierend und thermisch leitend mit der Wärmesenke (28), welche auf einer dem ersten Substrat (6) abgewandten Seite des zweiten Substrats (20) angeordnet wird, verbunden wird, **dadurch gekennzeichnet, dass**
das passive Bauelement (4), welches als mindestens ein Shunt-Widerstand ausgeführt ist, auf einer dem ersten Substrat (6) zugewandten Seite des zweiten Substrats (20) angeordnet wird, wobei das erste Substrat (6) eine Kavität (44) oder eine Aussparung (48) aufweist, in welche das passive Bauelement (4) hineinragt.

15. Verfahren zur Herstellung einer Anordnung (2) mit mindestens einem passiven Bauelement (4), einem ersten Substrat (6), einem mit dem ersten Substrat (6) elektrisch leitend verbundenen zweiten Substrat (20) und einer Wärmesenke (28),
wobei das erste Substrat (6) eine erste Leiterbahn (8) und eine zweite Leiterbahn (10) aufweist,
wobei über das passive Bauelement (4) eine elektrisch leitende Verbindung zwischen der ersten Leiterbahn (8) und der zweiten Leiterbahn (10) hergestellt wird,
wobei das zweite Substrat (20) eine zweite dielektrische Materiallage (22) umfasst und
wobei das passive Bauelement (4) über die zweite dielektrische Materiallage (22) des zweiten Substrats (20) elektrisch isolierend und thermisch leitend mit der Wärmesenke (28), welche auf einer dem ersten Substrat (6) abgewandten Seite des zweiten Substrats (20) angeordnet wird, verbunden wird, **dadurch gekennzeichnet, dass**
das passive Bauelement (4), welches als mindestens ein Shunt-Widerstand ausgeführt ist, auf einer dem zweiten Substrat (20) zugewandten Seite des ersten Substrats (6) angeordnet wird,
wobei das passive Bauelement (4) in einer Kavität (44) des ersten Substrats (6) angeordnet wird.

## Claims

1. Assembly (2) having at least one passive component (4), a first substrate (6), a second substrate (20) electrically conductively connected to the first substrate (6), and a heat sink (28),
wherein the first substrate (6) has at least one first conductor track (8) and at least one second conductor track (10),
wherein the first conductor track (8) is electrically conductively connected to the second conductor track (10) by way of the passive component (4),
wherein the second substrate (20) comprises a second dielectric material layer (22) and
wherein the passive component (4) is connected to the heat sink (28) in an electrically insulating and thermally conductive manner by way of the second dielectric material layer (22) of the second substrate (20), which heat sink (28) is arranged on a side of the second substrate (20) facing away from the first substrate (6),
**characterised in that**
the passive component (4), which takes the form of at least one shunt resistor, is arranged on a side of the second substrate (20) facing toward the first substrate (6),
wherein the first substrate (6) has a cavity (44) or an opening (48) into which the passive component (4) protrudes.

2. Assembly (2) according to claim 1,
wherein the passive component (4) takes the form of a sensor and
the assembly (2) comprises at least one terminal (32, 34) for contacting the sensor.

3. Assembly (2) according to one of claims 1 or 2,
wherein the passive component (4) is arranged on a side of the first substrate (6) facing away from the second substrate (20).

4. Assembly (2) having at least one passive component (4), a first substrate (6), a second substrate (20) electrically conductively connected to the first substrate (6), and a heat sink (28),
wherein the first substrate (6) has at least one first conductor track (8) and at least one second conductor track (10),
wherein the first conductor track (8) is electrically conductively connected to the second conductor track (10) by way of the passive component (4),
wherein the second substrate (20) comprises a second dielectric material layer (22) and
**characterised in that**
the passive component (4), which takes the form of at least one shunt resistor, is connected to the heat sink (28) in an electrically insulating and thermally conductive manner by way of the second dielectric material layer (22) of the second substrate (20), which heat sink (28) is arranged on a side of the second substrate (20) facing away from the first substrate (6),
wherein the passive component (4) is arranged on a side of the first substrate (6) facing toward the second substrate (20), wherein the passive component (4) is arranged in a cavity (44) of the first substrate (6).

5. Assembly (2) according to claim 4,
wherein the passive component (4) is electrically conductively connected to the first conductor track (8) by way of a first contact (4a) and to the second conductor track (10) by way of a second contact (4b),
wherein the passive component (4) has an active part (4c) arranged between the first contact (4a) and the second contact (4b), by way of which active part (4c) the passive component (4) is thermally conductively connected to a first metallisation (24) of the second substrate (20).

6. Assembly (2) according to claim 5,
wherein the thermally conductive connection of the active part (4c) of the passive component (4) to the first metallisation (24) of the second substrate (20) is produced by a material bond (54).

7. Assembly (2) according to one of the preceding claims,
wherein the first conductor track (8) and the second conductor track (10) are in each case connected to the second substrate (20) by way of at least one VIA (16),
wherein the passive component (4) has an active part (4c) and wherein the VIAs (16) are arranged to extend within a perpendicular projection surface (30) of the active part (4c) of the passive component (4).

8. Assembly (2) according to one of the preceding claims,
wherein the passive component (4) has a substantially C-shaped cross-sectional contour,
wherein contacts (4a, 4b) of the passive component (4) which are connected to the first and second conductor tracks (8, 10) are arranged to point toward one another.

9. Assembly (2) according to one of the preceding claims, wherein a first width (b1) of the second substrate (20) is smaller than a second width (b2) of the passive component (4).

10. Assembly (2) according to one of the preceding claims, wherein the passive component (4) is potted, in particular completely.

11. Assembly (2) according to one of the preceding claims, having an at least one semiconductor element (52) which is electrically conductively connected to the passive component (4), and a third substrate (56) which is connected to the first substrate (6) by way of the semiconductor element (52),
wherein the semiconductor element (52) and the third substrate (56) are arranged on a side of the first substrate (6) facing toward the second substrate (20), wherein the third substrate (56) comprises a third dielectric material layer (58) and
wherein the semiconductor element (52) is connected to the heat sink (28) in electrically insulating and thermally conductive manner by way of the third dielectric material layer (58) of the third substrate (56).

12. Assembly (2) according to claim 11,
wherein the second substrate (20) is thicker than the third substrate (56).

13. Power converter (62) having at least one assembly (2) according to one of the preceding claims.

14. Method for producing an assembly (2) having at least one passive component (4), a first substrate (6), a second substrate (20) electrically conductively connected to the first substrate (6), and a heat sink (28),
wherein the first substrate (6) has a first conductor track (8) and a second conductor track (10),
wherein an electrically conductive connection is produced between the first conductor track (8) and the second conductor track (10) by way of the passive component (4),
wherein the second substrate (20) comprises a second dielectric material layer (22) and
wherein the passive component (4) is connected to the heat sink (28) in an electrically insulating and thermally conductive manner by way of the second dielectric material layer (22) of the second substrate (20), which heat sink (28) is arranged on a side of the second substrate (20) facing away from the first substrate (6),
**characterised in that**
the passive component (4), which takes the form of at least one shunt resistor, is arranged on a side of the second substrate (20) facing toward the first substrate (6),
wherein the first substrate (6) has a cavity (44) or an opening (48) into which the passive component (4) protrudes.

15. A method for producing an assembly (2) having at least one passive component (4), a first substrate (6), a second substrate (20) electrically conductively connected to the first substrate (6), and a heat sink (28),
wherein the first substrate (6) has a first conductor track (8) and a second conductor track (10),
wherein an electrically conductive connection is produced between the first conductor track (8) and the second conductor track (10) by way of the passive component (4),
wherein the second substrate (20) comprises a second dielectric material layer (22) and
wherein the passive component (4) is connected to the heat sink (28) in an electrically insulating and thermally conductive manner by way of the second dielectric material layer (22) of the second substrate (20), which heat sink (28) is arranged on a side of the second substrate (20) facing away from the first substrate (6),
**characterised in that**
the passive component (4), which takes the form of at least one shunt resistor, is arranged on a side of the first substrate (6) facing toward the second substrate (20), wherein the passive component (4) is arranged in a cavity (44) of the first substrate (6).

## Revendications

1. Agencement (2) comprenant au moins un composant (4) passif, un premier substrat (6), un deuxième substrat (20) relié d'une manière conductrice de l'électricité au premier substrat (6) et un puits (28) de chaleur,
dans lequel le premier substrat (6) a au moins une première piste (8) conductrice et au moins une deuxième piste (10) conductrice, dans lequel la première piste (8) conductrice est reliée d'une manière conductrice de l'électricité à la deuxième piste (10) conductrice par l'intermédiaire du composant (4) passif,
dans lequel le deuxième substrat (20) comprend une deuxième couche (22) de matériau diélectrique et
dans lequel le composant (4) passif est, par l'intermédiaire de la deuxième couche (22) de matériau diélectrique du deuxième substrat (20), relié d'une manière isolée électriquement et conductrice thermiquement au puits (28) de chaleur, qui est disposé sur une face du deuxième substrat (20) non tournée vers le premier substrat (6),
**caractérisé en ce que**
le composant (4) passif, qui est réalisé sous la forme d'au moins une résistance shunt, est disposé sur une face du deuxième substrat (20) tournée vers le premier substrat (6), dans lequel le premier substrat (6) a une cavité (44) ou un évidement (48), dans lequel le composant (4) passif pénètre.

2. Agencement (2) suivant la revendication 1,
dans lequel le composant (4) passif est réalisé sous la forme d'un capteur et
l'agencement (2) comprend au moins une borne (32, 34) pour la mise en contact du capteur.

3. Agencement (2) suivant l'une des revendications 1 ou 2, dans lequel le composant (4) passif est disposé sur une face du premier substrat (6) non tournée vers le deuxième substrat (20).

4. Agencement (2) comprenant au moins un composant (4) passif, un premier substrat (6), un deuxième substrat (20) relié d'une manière conductrice de l'électricité au premier substrat (6) et un puits (28) de chaleur,
dans lequel le premier substrat (6) a au moins une première piste (8) conductrice et au moins une deuxième piste (10) conductrice, dans lequel la première piste (8) conductrice est reliée d'une manière conductrice de l'électricité à la deuxième piste (10) conductrice par l'intermédiaire du composant (4) passif,
dans lequel le deuxième substrat (20) comprend une deuxième couche (22) de matériau diélectrique et
**caractérisé en ce que**
le composant (4) passif est, par l'intermédiaire de la deuxième couche (22) de matériau diélectrique du deuxième substrat (20), relié d'une manière isolée électriquement et conductrice thermiquement au puits (28) de chaleur, qui est disposé sur une face du deuxième substrat (20) non tournée vers le premier substrat (6),
dans lequel le composant (4) passif est disposé sur une face du premier substrat (6) tournée vers le deuxième substrat (20),
dans lequel le composant (4) passif est disposé dans une cavité (44) du premier substrat (6).

5. Agencement (2) suivant la revendication 4,
dans lequel le composant (4) passif est, par un premier contact (4a), relié d'une manière conductrice de l'électricité à la première piste (8) conductrice et par un deuxième contact (4b) relié d'une manière conductrice de l'électricité à la deuxième piste (10) conductrice,
dans lequel le composant (4) passif a une partie (4c) active disposée entre le premier contact (4a) et le deuxième contact (4b), par laquelle le composant (4) passif est relié d'une manière conductrice thermiquement à une première métallisation (24) du deuxième substrat (20).

6. Agencement (2) suivant la revendication 5,
dans lequel la liaison conductrice thermiquement de la partie (4c) active du composant (4) passif à la première métallisation (24) du deuxième substrat (20) est ménagée par une liaison (54) à coopération de matière.

7. Agencement (2) suivant l'une des revendications précédentes, dans lequel la première piste (8) conductrice et la deuxième piste (10 conductrice sont reliées respectivement par au moins une VIA (16) au deuxième substrat (20),
dans lequel le composant (4) passif a une partie (4c) active et dans lequel les VIAs (16) sont disposées en s'étendant dans une surface (30) de projection verticale de la partie (4c) active du composant (4) passif.

8. Agencement (2) suivant l'une des revendications précédentes, dans lequel le composant (4) passif a un contour de section transversale sensiblement en forme de C,
dans lequel des contacts (4a, 4b) du composant (4) passif, qui sont reliés à la première et à la deuxième piste (8, 10) conductrices, sont disposés en étant tourné l'un vers l'autre.

9. Agencement (2) suivant l'une des revendications précédentes, dans lequel une première largeur (b1) du deuxième substrat (20) est plus petite qu'une deuxième largeur (b2) du composant (4) passif.

10. Agencement (2) suivant l'une des revendications précédentes, dans lequel le composant (4) passif est coulé, en particulier complètement.

11. Agencement (2) suivant l'une des revendications précédentes, comportant au moins un élément (52) à semiconducteur, qui est relié d'une manière conductrice électriquement au composant (4) passif et un troisième substrat (56), qui est relié au premier substrat (6) par l'élément (52) à semiconducteur,
dans lequel l'élément (52) à semiconducteur et le troisième substrat (56) sont disposés sur une face du premier substrat (6) tournée vers le deuxième substrat (20),
dans lequel le troisième substrat (56) comprend une troisième couche (58) de matériau diélectrique et
dans lequel l'élément (52) à semiconducteur et la troisième couche (58) de matériau diélectrique du troisième substrat (56) sont reliés d'une manière isolante électriquement et conductrice thermiquement au puits (28) de chaleur.

12. Agencement (2) suivant la revendication 11,
dans lequel le deuxième substrat (20) est réalisé de manière plus épaisse que le troisième substrat (56).

13. Convertisseur (62) ayant au moins un agencement (2) suivant l'une des revendications précédentes.

14. Procédé de fabrication d'un agencement (2) ayant au moins un composant (4) passif, un premier substrat (6), un deuxième substrat (20) relié d'une manière conductrice de l'électricité au premier substrat (6) et un puits (28) de chaleur,
dans lequel le premier substrat (6) a au moins une première piste (8) conductrice et au moins une deuxième piste (10) conductrice, dans lequel on produit par le composant (4) passif une liaison conductrice de l'électricité entre la première piste (8) conductrice et la deuxième piste (10) conductrice,
dans lequel le deuxième substrat (20) comprend une deuxième couche (22) de matériau diélectrique et
dans lequel le composant (4) passif est, par la deuxième couche (22) de matériau diélectrique du deuxième substrat (20), relié d'une manière isolante électriquement et conductrice thermiquement au puits (28) de chaleur,
qui est disposé sur une face du deuxième substrat (20) non tournée vers le premier substrat (6),
**caractérisé en ce que** l'
on met le composant (4) passif, qui est réalisé sous la forme d'au moins une résistance shunt sur une face du deuxième substrat (20) tournée vers le premier substrat (6), dans lequel le premier substrat (6) a une cavité (44) ou un évidement (48), dans lequel le composant (4) passif pénètre.

15. Procédé de fabrication d'un agencement (2) ayant au moins un composant (4) passif, un premier substrat (6), un deuxième substrat (20) relié d'une manière conductrice de l'électricité au premier substrat (6) et un puits (28) de chaleur,
dans lequel le premier substrat (6) a une première piste (8) conductrice et une deuxième piste (10) conductrice,
dans lequel on produit, par le composant (4) passif, une liaison conductrice de l'électricité entre la première piste (8) conductrice et la deuxième piste (10) conductrice,
dans lequel le deuxième substrat (20) comprend une deuxième couche (22) de matériau diélectrique et
dans lequel on relie le composant (4) passif, par la deuxième couche (22) de matériau diélectrique du deuxième substrat (20) d'une manière isolante électriquement et conductrice thermiquement, au puits (28) de chaleur, qui est disposé sur une face du deuxième substrat (20) non tournée vers le premier substrat (6),
**caractérisé en ce que** l'
on met le composant (4) passif, qui est réalisé sous la forme d'au moins une résistance shunt, sur une face du premier substrat (6) tournée vers le deuxième substrat (20),
dans lequel on met le composant (4) passif dans une cavité (44) du premier substrat (6).
